# EUROPEAN PATENT APPLICATION

(11) **EP 4 534 942 A1**
(43) Date of publication of application: **09.04.2025**
(21) Application number: 23815801.8
(22) Date of filing: 17.05.2023
(51) Int. Cl.: F28D 15/02

(54) **THERMAL DEVICE**

(30) Priority: 31.05.2022 JP 2022088973
(71) Applicant: Kyocera Corporation, Kyoto-shi, Kyoto 612-8501 (JP)
(72) Inventor: NAKAMURA, Kiyotaka, Kyoto-shi, Kyoto 612-8501 (JP); FUJITA, Naoya, Kyoto-shi, Kyoto 612-8501 (JP); KITAGAWA, Akihiko, Kyoto-shi, Kyoto 612-8501 (JP); FUNAHASHI, Akihiko, Kyoto-shi, Kyoto 612-8501 (JP)
(74) Representative: Viering, Jentschura & Partner mbB Patent- und Rechtsanwälte
(86) International application number: PCT/JP2023/018497
(87) International publication number: WO 2023/234042

(57) **Abstract**

A thermal device according to the present disclosure includes a ceramic container, a fluid, and a metal pipe. The container includes an internal space, an opening portion connected to the internal space, and a communication path connecting the internal space and the opening portion. The fluid is located in the internal space. A part of the metal pipe is inserted into the communication path, and another part is closed.

## Description

### TECHNICAL FIELD

The present disclosure relates to a thermal device.

### BACKGROUND OF INVENTION

A thermal device using latent heat of a phase transformation substance is known. Patent Document 1 discloses a heat pipe including a sealed container and a pipe for injecting a working liquid into the sealed container.

Patent Document 1 also discloses that the sealed container and the pipe are formed of a metal having excellent heat conductivity.

### CITATION LIST

### PATENT LITERATURE

Patent Document 1: JP 2000-213881 A

### SUMMARY

In one aspect of the present disclosure, a thermal device includes a ceramic container, a fluid, and a metal pipe. The container includes an internal space, an opening portion connected to the internal space, and a communication path connecting the internal space and the opening portion. The fluid is located in the internal space. A part of the metal pipe is inserted into the communication path, and another part is closed.

### BRIEF DESCRIPTION OF THE DRAWINGS

FIG. 1 is a perspective view of a heat dissipation device according to an embodiment.
FIG. 2 is a diagram of a first member according to the embodiment viewed from a Z axis negative direction side toward a Z axis positive direction.
FIG. 3 is a diagram of a second member according to the embodiment viewed from the Z axis positive direction side toward the Z axis negative direction.
FIG. 4 is a diagram of an intermediate member according to the embodiment viewed from the Z axis positive direction side toward the Z axis negative direction.
FIG. 5 is a diagram of a first groove forming region and a second groove forming region superimposed on the intermediate member.
FIG. 6 is a diagram for illustrating a flow of a fluid in the heat dissipation device according to the embodiment.
FIG. 7 is a diagram for illustrating a flow of a fluid in the heat dissipation device according to the embodiment.
FIG. 8 is a cross-sectional view taken along line VIII-VIII indicated by arrows in FIG. 5.
FIG. 9 is a cross-sectional view taken along arrows IX-IX in FIG. 8.
FIG. 10 is a schematic view illustrating an example of pressure welding of metal pipes.
FIG. 11 is a schematic view illustrating a first variation.

### DESCRIPTION OF EMBODIMENTS

Modes (hereinafter will be referred to as "embodiments") for implementing a thermal device according to the present disclosure will be described in detail below with reference to the accompanying drawings. Note that the present disclosure is not limited by the embodiments. The embodiments can be appropriately combined within a range so as not to contradict each other in terms of processing content. In the following embodiments, the same portions are denoted by the same reference signs, and redundant explanations are omitted.

In the following embodiments, expressions such as "constant", "orthogonal", "perpendicular", and "parallel" may be used, but these expressions do not mean exactly "constant", "orthogonal", "perpendicular", and "parallel". In other words, each of the expressions described above allows for deviations in, for example, manufacturing accuracy, or installation accuracy.

In each of the drawings, which will be referred to below, for ease of explanation, an X axis direction, a Y axis direction, and a Z axis direction that are orthogonal to each other may be defined to illustrate a rectangular coordinate system in which a Z axis positive direction is a vertically upward direction.

The related art in Patent Document 1 has a room for further improvement in terms of enhancing durability.

The present disclosure has been made in view of the above, and provides a thermal device having excellent durability.

In the following, a heat dissipation device, specifically a vapor chamber, which utilizes latent heat associated with evaporation and condensation of a fluid (an example of an working liquid or a phase transformation substance) and efficiently transfers heat from a high-temperature unit to a low-temperature unit will be described as an example of a thermal device according to the present disclosure. Hereinafter, the thermal device may be referred to as a heat dissipation device.

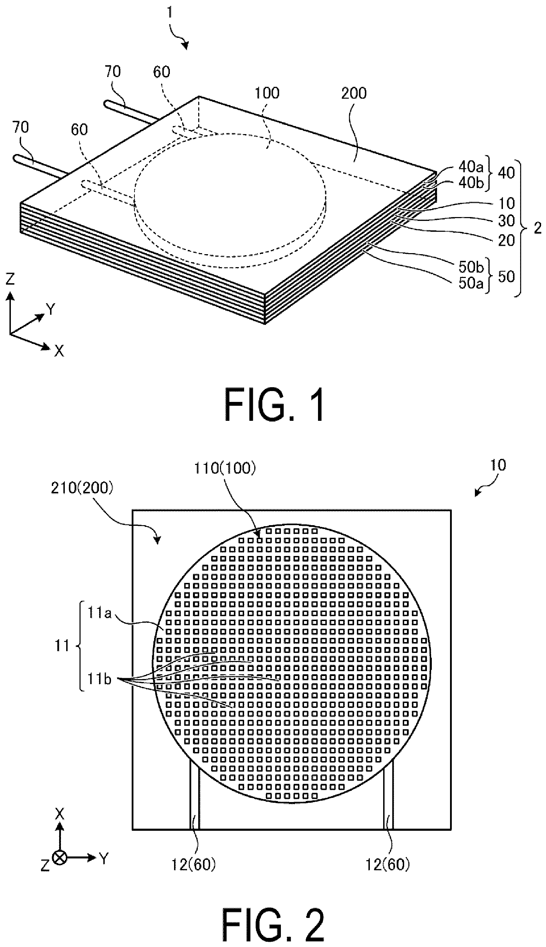

First, an overall configuration of a heat dissipation device according to an embodiment will be described with reference to FIG. 1. FIG. 1 is a perspective view of the heat dissipation device according to the embodiment.

As illustrated in FIG. 1, a heat dissipation device 1 may include a container 2. The container 2 may be made of ceramic. The container 2 may include a first member 10, a second member 20, and an intermediate member 30. The first member 10, the second member 20, and the intermediate member 30 may be all plate-shaped, and the intermediate member 30 may be sandwiched between the first member 10 and the second member 20.

The container 2 may include a first reinforcing member 40 and a second reinforcing member 50. The first reinforcing member 40 may be located on an upper surface (fifth surface) of the first member 10. The first reinforcing member 40 may be, for example, a laminate body of two reinforcing plates 40a and 40b. The first reinforcing member 40 is not limited thereto, and may be made of a single reinforcing plate. The second reinforcing member 50 may be located on a lower surface (sixth surface) of the second member 20. The second reinforcing member 50 may be, for example, a laminate body of two reinforcing plates 50a and 50b. The second reinforcing member 50 is not limited thereto, and may be made of a single reinforcing plate.

Note that the container 2 does not necessarily need to include the first reinforcing member 40 and the second reinforcing member 50.

The container 2 may include an actuating region 100 and a frame region 200. The actuating region 100 may be an internal space formed in the container 2, and a fluid may be sealed as a phase transformation substance in the internal space. For example, water, a hydrocarbon-based compound, an organic liquid (for example, ethanol, methanol, or the like), or a liquid such as ammonium may be used as the fluid.

The shape of the actuating region 100 when the container 2 is seen through from a direction perpendicular to the upper surface of the container 2 (that is, when the container 2 is seen through in a plan view) may be circular. Specifically, the actuating region 100 may have a cylindrical shape. With such a configuration, stress concentration on the corner portions is less likely to occur as compared with a case where the shape of the actuating region 100 is quadrangular in a plan view. Thus, the heat dissipation device 1 according to the embodiment can improve the durability of the container 2 against stress or the like generated by, for example, phase transformation of the fluid.

With such a configuration, compared to the case where the shape of the actuating region 100 is quadrangular in a plan view, the cross-sectional area of the portion where a communication path 60 to be described later and the actuating region 100 are connected to each other is increased, and thus injection of the fluid and discharge of the gas in the actuating region 100 can be performed more efficiently.

The frame region 200 may be a region surrounding the actuating region 100. In other words, the frame region 200 may be a region outside the actuating region 100 in the heat dissipation device 1. The actuating region 100 is substantially hollow, while the frame region 200 may be substantially solid.

The frame region 200 is a region intentionally formed wide in order to decrease, for example, leakage of the fluid or the vapor of the fluid from an interface between the first member 10 and the intermediate member 30 or between the second member 20 and the intermediate member 30, or to decrease the entry of the external atmosphere into the internal space of the actuating region 100 through the interface (that is, to ensure the sealing property).

The fluid may fill the internal space of the actuating region 100 at a ratio of 10 vol% or more and 95 vol% or less with respect to the total volume of the internal space, for example. Preferably, the ratio may be 30 vol% or more and 75 vol% or less. More preferably, the ratio may be 40 vol% or more and 65 vol% or less. The remaining portion of the internal space of the actuating region 100 other than the portion where the fluid is present may be in a vacuum state or a low-pressure state including some of the vaporized fluid. This can maintain vapor-liquid equilibrium even in high-temperature environments, making it less prone to dryout, while allowing efficient thermal diffusion even in low-temperature environments, thus achieving a high thermal diffusion characteristic in a wide temperature range.

The first member 10, the second member 20, the intermediate member 30, the first reinforcing member 40, and the second reinforcing member 50 may be made of ceramic. Examples of the ceramic constituting the first member 10, the second member 20, the intermediate member 30, the first reinforcing member 40, and the second reinforcing member 50 that can be used include, for example, alumina (Al₂O₃), zirconia (ZrO₂), silicon carbide (SiC), silicon nitride (Si₃N₄), aluminum nitride (AlN), cordierite (Mg₂Al₃(AlSi₅O₁₈)), and silicon impregnated silicon carbide (SiSiC). The ceramic constituting the first member 10, the second member 20, the intermediate member 30, the first reinforcing member 40, and the second reinforcing member 50 may be a single crystal.

A metal heat dissipation device is difficult to make thinner due to the difficulty in obtaining rigidity due to materials and manufacturing methods. Since the metal heat dissipation device includes a metal portion that contacts the fluid, there is a room for improvement in corrosion resistance. In contrast, since the heat dissipation device 1 according to the embodiment is composed of the first member 10, the second member 20, the intermediate member 30, the first reinforcing member 40, and the second reinforcing member 50, which are all made of ceramic, the device can be made thinner and more corrosion-resistant than the heat dissipation device made of metal.

In the example illustrated in FIG. 1, the heat dissipation device 1 is placed with the first member 10 facing upward, but the posture of the heat dissipation device 1 is not limited to the example illustrated in FIG. 1. For example, the heat dissipation device 1 may be placed with the first member 10 facing downward. The heat dissipation device 1 is not limited to the horizontal arrangement as illustrated in FIG. 1, but may be arranged vertically.

The container 2 may include a plurality of (in this case, two) communication paths 60 that connect the internal space of the actuating region 100 to the outside. One of the two communication paths 60 may be used as, for example, an injection hole for injecting a fluid. The other of the two communication paths 60 may be used as, for example, a discharge hole for discharging gas in the actuating region 100. In this case, in the manufacturing process of the heat dissipation device 1, the fluid may be injected into the internal space of the actuating region 100 through one communication path 60, and accordingly, a gas present in the internal space of the actuating region 100 may be discharged to the outside through the other communication path 60.

The two communication paths 60 may open to a side surface of the container 2. The two communication paths 60 may linearly extend from the side surface of the container 2 toward the actuating region 100.

The two communication paths 60 may open to the same side surface of the container 2. In this case, by directing the side surface to which the two communication paths 60 open upward, the fluid can be efficiently injected into the actuating region 100, and the gas present in the internal space of the actuating region 100 can be efficiently discharged.

A heat source may be disposed on the upper surface of the container 2. Therefore, by locating the communication paths 60 on the side surface of the container 2, a wider installation space for the heat source can be secured than in the case where the communication paths 60 are located on the upper surface of the container 2.

Note that the two communication paths 60 may open to different side surfaces of the container 2, respectively. The heat dissipation device 1 does not necessarily include the plurality of communication paths 60. For example, the heat dissipation device 1 may be configured to include only one of the two communication paths 60 described above.

A metal pipe 70 is inserted into the communication path 60, and the communication path 60 may be sealed by the metal pipe 70. When the communication path 60 is blocked by the metal pipe 70, the internal space of the heat dissipation device 1 is sealed and the fluid is enclosed in the actuating region 100. As described above, the heat dissipation device 1 may be a sealed container with a sealed interior. The specific configuration of the communication path 60 and the metal pipe 70 will be described later.

The configuration of the first member 10 will be described with reference to FIG. 2. FIG. 2 is a diagram of the first member 10 according to the embodiment viewed from the Z axis negative direction side toward the Z axis positive direction.

FIG. 2 illustrates a lower surface of the first member 10, specifically, a surface (third surface) facing the upper surface (first surface) of the intermediate member 30. As illustrated in FIG. 2, the first member 10 may include a first groove portion 11 having a lattice shape on the third surface.

The first groove portion 11 may include a first recessed portion 11a recessed with respect to the third surface and a plurality of first protruding portions 11b located within the first recessed portion 11a. The first recessed portion 11a is located at the center portion of the third surface, and its contour in a plan view may be, for example, a circle. The plurality of first protruding portions 11b may be arranged longitudinally and laterally at intervals from each other within the first recessed portion 11a. The first recessed portion 11a and the plurality of first protruding portions 11b may make the first groove portion 11 have a lattice shape.

Hereinafter, a region where the first groove portion 11 is located on the third surface of the first member 10 will be referred to as a "first groove forming region 110". The first groove forming region 110 may constitute a part of the actuating region 100. The first member 10 may also include a first frame region 210 having a rectangular frame shape surrounding the first groove forming region 110. The first frame region 210 may constitute a part of the frame region 200.

A plurality of (here, two) communication grooves 12 may be located in the first frame region 210. The communication groove 12 may constitute a part of the communication path 60. One end of the communication groove 12 may be located at the outer edge of the first member 10, and the other end of the communication groove 12 may be located at the outer edge of the first recessed portion 11a. A depth of the communication groove 12 in the thickness direction of the first member 10 (here, the Z axis direction) may be greater than a depth of the first recessed portion 11a in the thickness direction of the first member 10.

The reinforcing plate 40b of the first reinforcing member 40 described above may be located at the center portion of the upper surface (fifth surface) located opposite to the lower surface (third surface) of the first member 10.

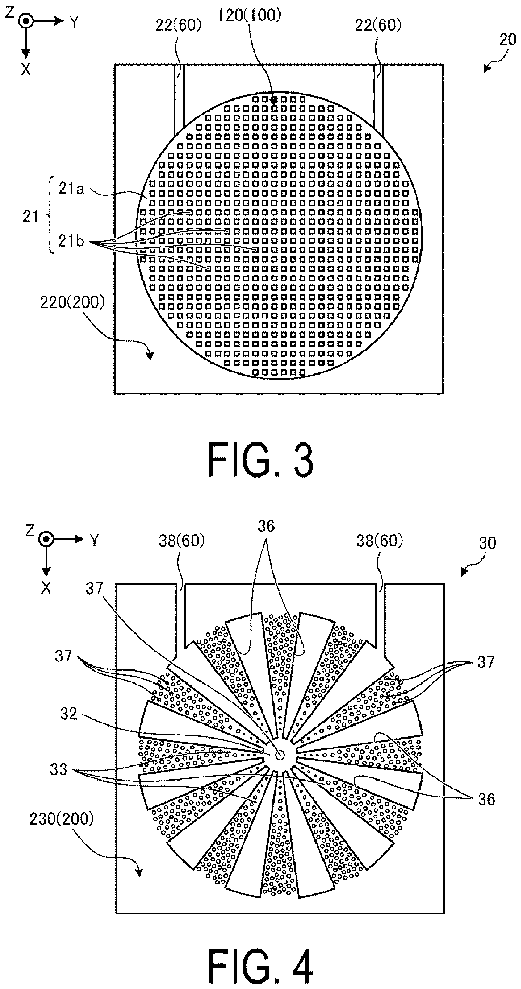

Next, the configuration of the second member 20 will be described with reference to FIG. 3. FIG. 3 is a diagram of the second member 20 according to the embodiment viewed from the Z axis positive direction side toward the Z axis negative direction.

FIG. 3 illustrates the upper surface of the second member 20, specifically, a surface (fourth surface) facing the lower surface (second surface) of the intermediate member 30. As illustrated in FIG. 3, the second member 20 includes a second groove portion 21 having a lattice shape on the fourth surface.

The second groove portion 21 may include a second recessed portion 21a recessed with respect to the fourth surface and a plurality of second protruding portions 21b located within the second recessed portion 21a. The second recessed portion 21a may be located at the center portion of the fourth surface, and its contour in a plan view may be, for example, a circle. The plurality of second protruding portions 21b may be arranged longitudinally and laterally at intervals from each other within the second recessed portion 21a. The second recessed portion 21a and the plurality of second protruding portions 21b may make the second groove portion 21 have a lattice shape.

Hereinafter, a region where the second groove portion 21 is located on the fourth surface of the second member 20 will be referred to as a "second groove forming region 120". The second groove forming region 120 may constitute a part of the actuating region 100. The second member 20 may include a second frame region 220 having a rectangular frame shape surrounding the second groove forming region 120. The second frame region 220 may constitute a part of the frame region 200.

The size of the second groove forming region 120 in the second member 20 may be the same as the size of the first groove forming region 110 in the first member 10. The position of the second groove forming region 120 on the fourth surface of the second member 20 may be the same as the position of the first groove forming region 110 on the third surface of the first member 10.

Thus, by forming the first groove portion 11 and the second groove portion 21 having a lattice shape, the fluid can be efficiently circulated in the internal space of the heat dissipation device 1. Note that each of the first groove portion 11 and the second groove portion 21 need not necessarily have a lattice shape.

A plurality of (here, two) communication grooves 22 may be located in the second frame region 220. The communication groove 22 may constitute a part of the communication path 60. One end of the communication groove 22 may be located at the outer edge of the second member 20, and the other end of the communication groove 22 may be located at the outer edge of the second recessed portion 21a. A depth of the communication groove 22 in the thickness direction of the second member 20 may be greater than a depth of the second recessed portion 21a in the thickness direction of the second member 20.

The configuration of the intermediate member 30 will be described with reference to FIG. 4. FIG. 4 is a diagram of the intermediate member 30 according to the embodiment viewed from the Z axis positive direction side toward the Z axis negative direction.

As illustrated in FIG. 4, the intermediate member 30 may include a third frame region 230 having a rectangular frame shape. The third frame region 230 may constitute a part of the frame region 200. The intermediate member 30 may include a circular center portion 32 in a plan view located on an inner side of the third frame region 230 and a plurality of connecting portions 33 which may be located between the center portion 32 and the third frame region 230 and connect the center portion 32 and the third frame region 230. In the example illustrated in FIG. 4, the center portion 32 may be located at the center of intermediate member 30. The plurality of connecting portions 33 may be spaced apart from each other and extend radially while widening from the center portion 32 toward the third frame region 230.

The intermediate member 30 may further include a plurality of vapor holes 36 and a plurality of reflux holes 37. Each of the plurality of vapor holes 36 and each of the plurality of reflux holes 37 may penetrate the upper surface (first surface) and the lower surface (second surface) of the intermediate member 30.

The plurality of vapor holes 36 may function as a part of a path for the vapor of the fluid. Each of the plurality of vapor holes 36 may be located between two adjacent connecting portions 33. That is, the plurality of vapor holes 36 and the plurality of connecting portions 33 may be alternately located in the circumferential direction. As in the plurality of connecting portions 33, the plurality of vapor holes 36 may be spaced apart from each other and extend radially while widening from the center portion 32 toward the third frame region 230.

The plurality of reflux holes 37 may function as a part of a path for the fluid. The reflux holes 37 may be micropores, each having an opening area smaller than the vapor hole 36 described above. Specifically, the reflux holes 37 may be small enough to allow capillary phenomenon to occur in the fluid passing through the reflux holes 37.

A plurality of (here, two) communication holes 38 may be located in the third frame region 230. The communication hole 38 may constitute a part of the communication path 60. One end of the communication hole 38 may be located at the outer edge of the intermediate member 30, and the other end of the communication hole 38 may be located at the outer edge of the vapor hole 36. The communication hole 38 may penetrate the intermediate member 30 in the thickness direction.

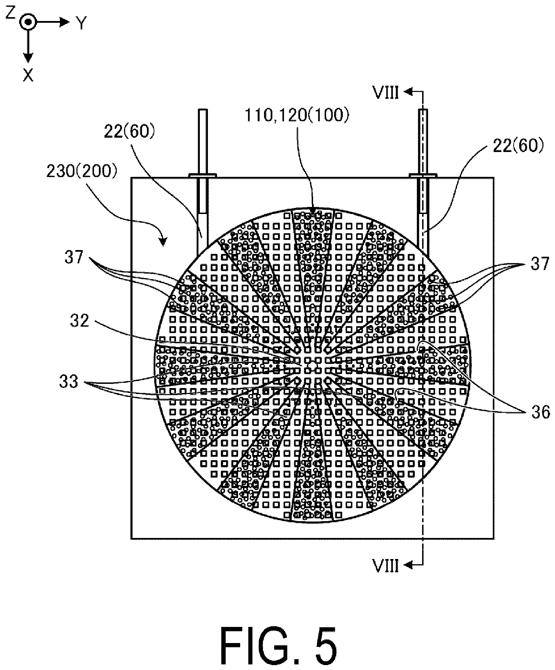

FIG. 5 is a diagram of the first groove forming region 110 in FIG. 2 and the second groove forming region 120 in FIG. 3, which are superimposed on the intermediate member 30 in FIG. 4. As illustrated in FIG. 5, the first groove forming region 110 and the second groove forming region 120 may overlap the third frame region 230 of the intermediate member 30.

The actuating region 100 of the heat dissipation device 1 may have an internal space sandwiched between the first groove forming region 110 and the second groove forming region 120, and a fluid may be enclosed in the internal space. The intermediate member 30 may be interposed between the first groove forming region 110 and the second groove forming region 120 in the internal space, and thus the actuating region 100 may be partitioned into a first space sandwiched between the first groove forming region 110 and the intermediate member 30 and a second space sandwiched between the second groove forming region 120 and the intermediate member 30. The first space and the second space may be connected via the vapor holes 36 and the reflux holes 37 formed in the intermediate member 30.

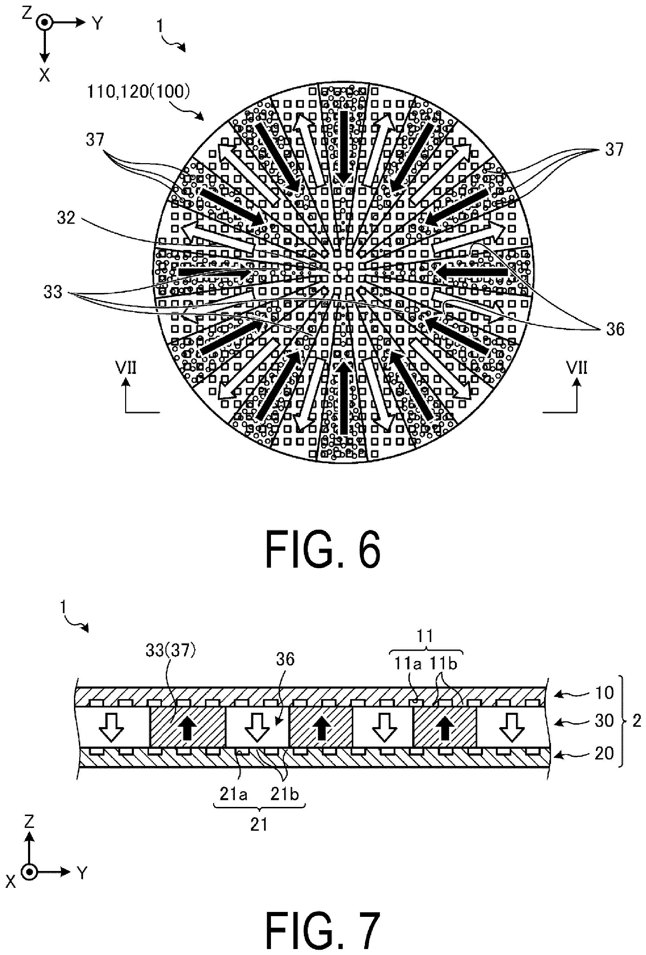

The flow of the fluid in the heat dissipation device 1 according to the embodiment will be described with reference to FIGs. 6 and 7. FIGs. 6 and 7 illustrate the flow of the fluid in the heat dissipation device 1 according to the embodiment. Note that FIG. 6 is a diagram in which the third frame region 230 is omitted from the diagram illustrated in FIG. 5, and FIG. 7 is a cross-sectional view taken along arrows VII-VII in FIG. 6. In FIGs. 6 and 7, the vapor flow is indicated by white arrows, and the liquid flow is indicated by black arrows. In FIG. 7, the first reinforcing member 40 and the second reinforcing member 50 are omitted.

The fluid is vaporized into a vapor by being heated by a heat source. As described above, the heat source may be disposed at the center portion of the upper surface (fifth surface) of the first member 10 (see FIGs. 1 and 2). Thus, the vapor of the fluid is generated at the center portion of the first space (space sandwiched between the first member 10 and the intermediate member 30).

The vapor of the fluid diffuses in the in-plane direction (XY plane direction) of the heat dissipation device 1 through the first groove portion 11 of the first groove forming region 110 (see white arrows in FIG. 6), while moving through the plurality of vapor holes 36 to the second space (space sandwiched between the second member 20 and intermediate member 30) (see the white arrows in FIG. 7).

The vapor that has moved to the second space condenses into a liquid as the temperature decreases. The liquefied fluid moves through the second groove forming region 120 toward the center portion of the heat dissipation device 1 due to the capillary action of the second groove portion 21 (see the black arrows in FIG. 6). In this process, the fluid enters the reflux holes 37 and is returned to the first space by the capillary action of the reflux holes 37 (see the black arrows in FIG. 7). By repeating the above cycle, the heat dissipation device 1 can transfer heat from the heat source.

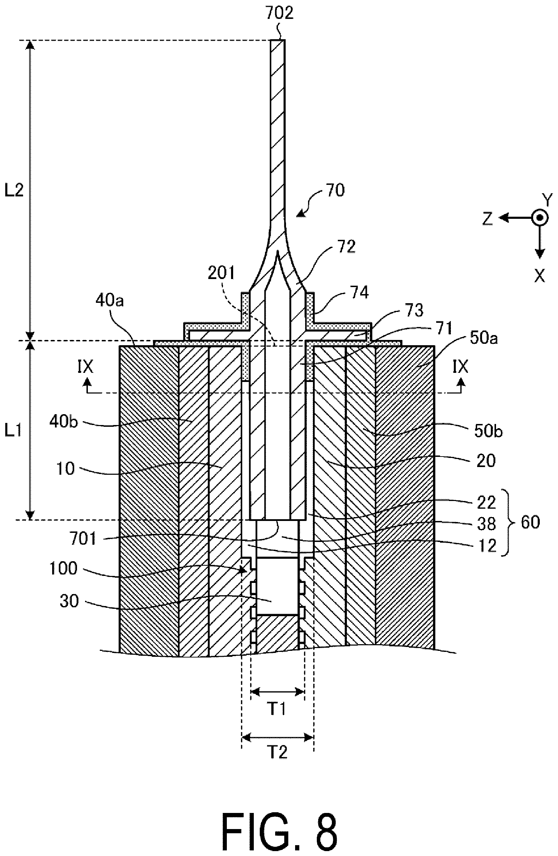

The configuration of the metal pipe 70 will be described with reference to FIG. 8. FIG. 8 is a cross-sectional view taken along arrows VIII-VIII in FIG. 5.

As illustrated in FIG. 8, the communication path 60 may include the communication grooves 12 and 22 and the communication hole 38. As described above, the depth of the communication groove 12 in the thickness direction (Z axis direction) of the first member 10 may be greater than the depth of the first recessed portion 11a of the actuating region 100 in the thickness direction of the first member 10. The depth of the communication groove 22 in the thickness direction of the second member 20 may be greater than the depth of the second recessed portion 21a of the actuating region 100 in the thickness direction of the second member 20. Therefore, a thickness T1 of the actuating region 100 may be configured to be thinner than a thickness T2 of the communication path 60. With such a configuration, the cycle of evaporation and condensation of the fluid in the actuating region 100 (internal space) can be repeated more quickly, and the circulation of the fluid can be performed efficiently.

The metal pipe 70 may seal the communication path 60 by inserting a part of the metal pipe 70 into the communication path 60 and closing another part of the metal pipe 70. One end 701 of the metal pipe 70 may be located in the communication path 60. In other words, the metal pipe 70 may not be located in the actuating region 100. Such a configuration can reduce a decrease in the effective volume of the actuating region 100 (internal space).

The one end 701 of the metal pipe 70 may be located closer to the actuating region 100 (internal space) side than the center of the communication path 60 in the longitudinal direction. With such a configuration, when the metal pipe 70 is inserted, the metal pipe 70 is not easily displaced, and the positional accuracy of the metal pipe 70 is improved. The other end 702 of the metal pipe 70 may be located outside the communication path 60.

As illustrated in FIG. 8, the metal pipe 70 may include an insertion portion 71, a projecting portion 72, and a flange portion 73.

The insertion portion 71 is a portion of the metal pipe 70 located inside the communication path 60. The projecting portion 72 is a portion of the metal pipe 70 located outside the communication path 60. A length L1 of the insertion portion 71 may be shorter than a length L2 of the projecting portion 72. With such a configuration, heat of the metal pipe 70 can be more radiated to the projecting portion 72 compared to a case where the length L1 of the insertion portion 71 is longer than the length L2 of the projecting portion 72, and stresses applied to the container 2 can be alleviated. Note that, in FIG. 8, as an example, the length L1 of the insertion portion 71 and the length L2 of the projecting portion 72 are illustrated with the lower surface of the flange portion 73 as a reference, but the reference position is not limited thereto. For example, the position of an opening portion 201 may be used as a reference.

The flange portion 73 may be located in the projecting portion 72. The flange portion 73 may be bonded to a surface of the container 2 at which the opening portion 201 of the communication path 60 is located via a brazing material 74 such as silver brazing. When the flange portion 73 and the container 2 are bonded to each other via the brazing material 74, the connection durability between the container 2 and the metal pipe 70 is high.

The brazing material 74 may be located not only between the flange portion 73 and the container 2 but also between the insertion portion 71 and the communication path 60, for example. With such a configuration, the connection durability between the container 2 and the metal pipe 70 is high. The brazing material 74 may be located to extend over the surface of the flange portion 73 on the side opposite to the surface bonded to the container 2 and the opening surface of the communication path 60 in the container 2. That is, the brazing material 74 may be located to entirely cover the flange portion 73. With such a configuration, the connection durability between the container 2 and the metal pipe 70 is high.

Note that the method for bonding the metal pipe 70 and the container 2 is not limited to the above-described method. It is sufficient that the metal pipe 70 and the container 2 can be bonded to each other, and the flange portion 73 is not necessarily a necessary configuration.

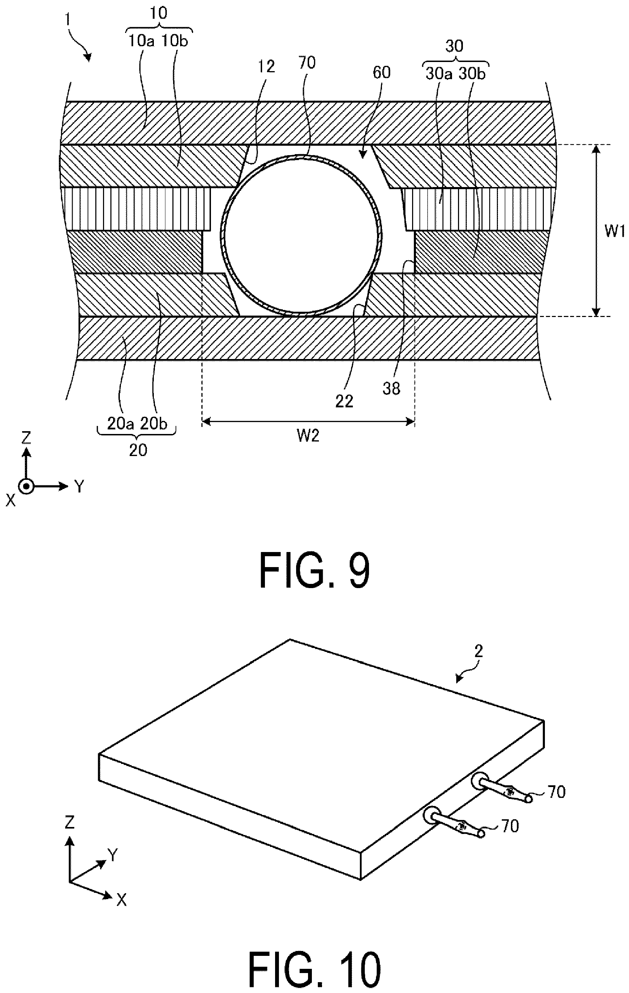

Configurations of the communication path 60 and the metal pipe 70 in a cross-sectional view in which the communication path 60 is cut along a plane orthogonal to the longitudinal direction of the communication path 60 (hereinafter, also simply referred to as a cross-sectional view) will be described. FIG. 9 is a cross-sectional view taken along arrows IX-IX in FIG. 8. In FIG. 9, the first reinforcing member 40 and the second reinforcing member 50 are omitted.

As illustrated in FIG. 9, in a cross-sectional view, the shape of the communication path 60 may be a polygonal shape having a plurality of corners. As will be described later, the first member 10, the second member 20, and the intermediate member 30 constituting the container 2 are obtained by processing a laminate body including a plurality of layers. Specifically, the first member 10 including the communication groove 12 is obtained by processing the laminate body made of layers 10a and 10b. Similarly, the second member 20 including the communication groove 22 is obtained by processing the laminate body made of the layers 20a and 20b. Similarly, the intermediate member 30 including the communication hole 38 is obtained by processing the laminate body made of layers 30a and 30b. That is, since the communication path 60 is constituted by a plurality of layers, the communication path 60 has a polygonal shape having a plurality of corners.

As illustrated in FIG. 9, the shape of the metal pipe 70 may be circular in a cross-sectional view. Therefore, the shapes of the metal pipe 70 and the communication path 60 may be non-similar to each other. The heat dissipation device 1 may have a space between the outer peripheral surface of the metal pipe 70 and the inner peripheral surface of the communication path 60.

The first member 10, the second member 20, and the intermediate member 30 constituting the communication path 60 are made of a ceramic. Ceramics generally have a larger Young's modulus than metals, that is, have higher rigidity. The metal pipe 70 made of a metal is deformed (expands) in a direction of thermally expanding the communication path 60. With such deformation, stress is generated in the communication path 60. When a space is provided between the outer peripheral surface of the metal pipe 70 and the inner peripheral surface of the communication path 60, even when the metal pipe 70 expands, the expansion of the metal pipe 70 can be released to the space as compared with a case where no space is provided. Therefore, since the shapes of the metal pipe 70 and the communication path 60 in the cross-sectional view are non-similar to each other, the stress applied to the container 2 due to the deformation of the metal pipe 70 caused by the temperature change (particularly, the temperature rise) can be alleviated.

As illustrated in FIG. 9, in the cross-sectional view, one interior angle in the shape of the communication path 60 may be 90° or more, and the total of all interior angles may be 360° or more. This can further alleviate the stress applied to the corner portion of the communication path 60 when the metal pipe 70 expands due to heat, and reduce the occurrence of cracks in the container 2.

As illustrated in FIG. 9, the shape of the communication path 60 may be such that a longitudinal width W1 and a lateral width W2 are different from each other. With such a configuration, when the metal pipe 70 expands due to heat, the expansion force in the short width direction (the Z axis direction in the example illustrated in FIG. 9) of the communication path 60 can be released to the space in the long width direction (the Y-axis direction in the example illustrated in FIG. 9).

As illustrated in FIG. 9, the metal pipe 70 may be in contact with the communication path 60 at a plurality of points in a cross-sectional view. Although FIG. 9 illustrates an example in which the metal pipe 70 is in contact with the communication path 60 at two points, the metal pipe 70 may be in contact with the communication path 60 at three or more points in a cross-sectional view. With such a configuration, the metal pipe 70 can be supported with high accuracy.

The cross-sectional shape of the communication path 60 is not limited to the example illustrated in FIG. 9. For example, the communication path 60 may have a square shape or a rectangular shape in a cross-sectional view. The communication path 60 may have a circular shape which is non-similar to the cross-sectional shape of the metal pipe 70 in a cross-sectional view, for example, an elliptical shape.

As described above, the heat dissipation device 1 according to the embodiment may be a sealed ceramic container. That is, the first member 10, the second member 20, and the intermediate member 30 may be made of ceramics.

Ceramics generally have a larger Young's modulus than metals, that is, have higher rigidity. The metal pipe 70 made of a metal is thermally deformed in a direction of expanding the communication path 60. When the heat dissipation device is made of the metal and the metal pipe 70 is deformed in the direction of expanding the communication path 60, the communication path 60 tends to be deformed easily along with the deformation. On the other hand, in the ceramic heat dissipation device 1, the communication path 60 is less likely to be deformed compared to the metal heat dissipation device, even when the metal pipe 70 is deformed in the direction of expanding the communication path 60. Therefore, when compared to the metal heat dissipation device, the ceramic heat dissipation device 1 can easily ensure the sealing property against a temperature change (particularly, a temperature rise).

In another aspect, ceramics have a lower thermal expansion coefficient than the majority of metals, except for some metals such as W (tungsten), Mo (molybdenum), Ti (titanium), Nb (niobium), Zr (zirconium), and the like. That is, the ceramic heat dissipation device 1 is less likely to be thermally deformed compared to the metal heat dissipation device. For this reason, the ceramic heat dissipation device 1 is more likely to maintain a state in which the metal pipe 70 presses the communication path 60 compared to the metal heat dissipation device. Therefore, the ceramic heat dissipation device 1 can more easily ensure the sealing property with respect to the heat cycle compared to the metal heat dissipation device. The ceramic heat dissipation device 1 is less susceptible to corrosion when exposed to acid or high-temperature steam, and less susceptible to oxidation at high temperatures, compared to the metal heat dissipation device.

Examples of the ceramic constituting the first member 10, the second member 20, and the intermediate member 30 include alumina, zirconia, and silicon carbide, as described above. Among these ceramics, alumina is preferably used as the ceramic constituting the first member 10, the second member 20, and the intermediate member 30, as it is inexpensive, causes only little harm to the environment, and is excellent in workability.

The interior of the heat dissipation device 1 according to the embodiment is in a reduced pressure state (including vacuum) when no heat source is disposed on the upper surface (fifth surface) of the first member 10. On the other hand, when the heat source is disposed on the upper surface of the first member 10, the interior of the heat dissipation device 1 is in a pressurized state as the fluid vaporizes and expands in volume. Thus, the pressure state inside the heat dissipation device 1 alternates between the reduced pressure state and the pressurized state depending on the presence or absence of the heat source.

On the other hand, the metal pipe 70 according to the embodiment presses the communication path 60, making it easy to ensure the sealing property in both the reduced pressure state and the pressurized state.

An example of a method for manufacturing the heat dissipation device 1 according to the embodiment will be described. First, green sheets are formed by a doctor blade method or a roll compaction method using materials of the first member 10, the second member 20 and the intermediate member 30. Then, by layering a plurality of green sheets, a laminate body is obtained.

Subsequently, the obtained laminate body is subjected to laser processing or die punching, thereby obtaining the respective compacts of the first member 10, the second member 20 and the intermediate member 30. For example, a compact of the intermediate member 30 having therein a plurality of vapor holes 36, a plurality of reflux holes 37, and a plurality of communication holes 38 formed can be obtained, by applying laser processing to the laminate body. By applying laser processing to the obtained laminate body, a compact of the first member 10 having therein a plurality of communication grooves 12 and the first groove forming region 110 formed is obtained. By applying laser processing to the obtained laminate body, a compact of the second member 20 having therein a plurality of communication grooves 22 and the second groove forming region 120 formed is obtained.

Subsequently, the compacts of the first member 10, the second member 20, and the intermediate member 30 are respectively layered and fired in the order of the second member 20, the intermediate member 30, and the first member 10, thereby obtaining a sintered body of the container 2 in which the first member 10, the second member 20, and the intermediate member 30 are integrated. In this way, the first member 10, the second member 20 and the intermediate member 30 are integrally formed. Since no adhesive or the like is necessary, the highly reliable heat dissipation device 1 can be obtained.

Note that the method of obtaining the respective compacts of the first member 10, the second member 20, and the intermediate member 30 is not limited to the method described above. For example, the green sheets may be processed and then layered to obtain the respective compacts. In the above example, the compact of the container 2 is obtained by producing the respective compacts of the first member 10, the second member 20, and the intermediate member 30 individually and then layering them. Alternatively, the compact of the container 2 may be obtained by sequentially layering processed green sheets, for example.

Subsequently, the insertion portion 71 of the metal pipe 70 is inserted into each of the plurality of communication paths 60. Thereafter, the flange portion 73 of the metal pipe 70 and the container 2 are bonded to each other via the brazing material 74.

Subsequently, the fluid is injected into the sintered body from one of the two metal pipes 70, for example. The gas present in the sintered body is discharged to the outside from the other metal pipe 70 in accordance with injection of the fluid.

Subsequently, a pressure reducing device such as a vacuum pump is used to evacuate the inside of the sintered body through the communication path 60. Note that the inner portion of the sintered body is desirably in a vacuum state, but it may not be in a strict vacuum state and, for example, may be under reduced pressure close to a vacuum state.

Subsequently, the communication path 60 is sealed in a state in which the inside of the sintered body is evacuated. Specifically, as illustrated in FIG. 10, one or a plurality of portions of the projecting portion 72 (see FIG. 8) of the metal pipe 70 are pressure-welded to seal the inside of the container 2. Note that the method of sealing the communication path 60 is not limited to the example described above. For example, the communication path 60 may be sealed by welding the other end 702 (see FIG. 8) of the metal pipe 70. Alternatively, both pressure-welding and welding may be performed to seal the communication path 60.

### First Variation

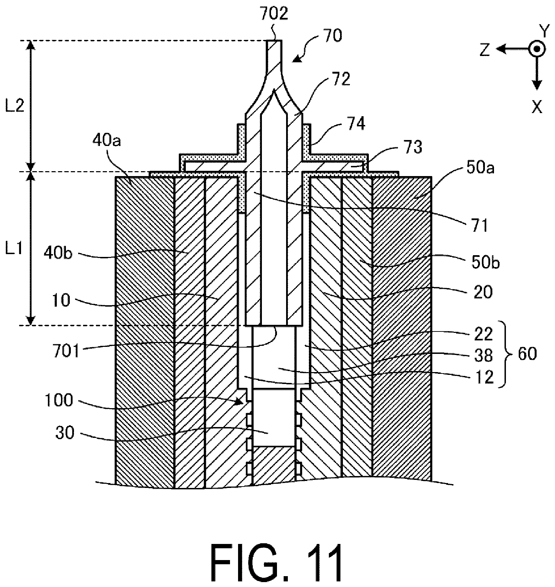

In the above-described embodiment, as illustrated in FIG. 8, the length L1 of the insertion portion 71 of the metal pipe 70 is shorter than the length L2 of the projecting portion 72, but it is not limited to such a configuration. For example, as illustrated in FIG. 11, the length L1 of the insertion portion 71 may be longer than the length L2 of the projecting portion 72. With such a configuration, the metal pipe 70 is less likely to come off the container 2.

As described above, the thermal device (as an example, the heat dissipation device 1) according to the embodiment includes a ceramic container (as an example, the container 2), a fluid (as an example, the fluid), and a metal pipe (as an example, the metal pipe 70). The container includes an internal space (as an example, the actuating region 100), an opening portion (as an example, the opening portion 201) connected to the internal space, and a communication path (as an example, the communication path 60) configured to connect the internal space and the opening portion. The fluid is located in the internal space. A part of the metal pipe is inserted into the communication path and another part is closed.

Since the container of the thermal device according to the embodiment is made of ceramic, it is excellent in durability against temperature change as compared with the metal container described in Patent Document 1. In the thermal device according to the embodiment, since a part of the metal pipe is located in the communication path of the thermal device, even when the metal pipe is deformed due to temperature change, stress can be received in the entire container, and the stress can be alleviated.

In the thermal device according to the embodiment, since the communication path and the metal pipe are non-similar to each other, a gap is formed between the communication path and the metal pipe, and when the metal pipe is deformed, stress can be further reduced.

Thus, the thermal device according to the embodiment can improve the durability.

The thermal device according to the present disclosure is not limited to the heat dissipation device. For example, the thermal device according to the present disclosure may be a heat storage device that stores latent heat associated with phase transformation of a heat storage material (an example of the phase transformation substance) as thermal energy. In that case, a material that performs solid-liquid phase transformation or a material that performs solid-solid phase transformation is used as the heat storage material. Thus, the phase transformation substance is not necessarily required to undergo gas-liquid phase transformation. In other words, the phase transformation substance does not necessarily be liquid, but may be solid.

Note that the embodiments disclosed herein are exemplary in all respects and not restrictive. The above-described embodiments can be embodied in a variety of forms. The above-described embodiments may be omitted, substituted or modified in various forms without departing from the scope and spirit of the appended claims.

### REFERENCE SIGNS

1 Heat dissipation device
2 Container
10 First member
10a, 10b Layer
11 First groove portion
11a First recessed portion
11b First protruding portion
12 Communication groove
20 Second member
20a, 20b Layer
21 Second groove portion
21a Second recessed portion
21b Second protruding portion
22 Communication groove
30 Intermediate member
30a, 30b Layer
32 Center portion
33 Connecting portion
36 Vapor hole
37 Reflux hole
38 Communication hole
40 First reinforcing member
40a, 40b Reinforcing plate
50 Second reinforcing member
50a, 50b Reinforcing plate
60 Communication path
70 Metal pipe
71 Insertion portion
72 Projecting portion
73 Flange portion
74 Brazing material
100 Actuating region
110 First groove forming region
120 Second groove forming region
200 Frame region
201 Opening portion
210 First frame region
220 Second frame region
230 Third frame region
701 One end
702 The other end
L1 Length of insertion portion
L2 Length of projecting portion
T1 Thickness of actuating region
T2 Thickness of communication path
W1 Longitudinal width
W2 Lateral width

## Claims

1. A thermal device comprising:
a container made of ceramic comprising an internal space, an opening portion connected to the internal space, and a communication path connecting the internal space and the opening portion;
a fluid located in the internal space; and
a metal pipe of which a part is inserted into the communication path and another part is closed.

2. The thermal device according to claim 1, wherein
the opening portion is located at a side surface of the container.

3. The thermal device according to claim 2, further comprising:
a plurality of the opening portions and a plurality of the communication paths, wherein
the plurality of opening portions are located at the same side surface.

4. The thermal device according to claim 1, wherein
one end of the metal pipe is located in the communication path.

5. The thermal device according to claim 4, wherein
the one end of the metal pipe is located closer to a side of the internal space than a center of the communication path in a longitudinal direction.

6. The thermal device according to claim 1, wherein
the metal pipe is in contact with the communication path at two or more points in a cross-sectional view obtained by cutting the communication path along a plane orthogonal to the longitudinal direction of the communication path.

7. The thermal device according to claim 1, wherein
a thickness of the internal space is less than a thickness of the communication path.

8. The thermal device according to claim 1, wherein
the internal space has a circular shape when the container is seen in a plane perspective view.

9. The thermal device according to claim 1, wherein
a shape of the metal pipe and a shape of the communication path are non-similar to each other in a cross-sectional view obtained by cutting the communication path along a plane orthogonal to the longitudinal direction of the communication path.

10. The thermal device according to claim 9, wherein
the shape of the communication path in the cross-sectional view is a polygonal shape having a plurality of corners.

11. The thermal device according to claim 9, wherein
the shape of the metal pipe in the cross-sectional view is a circular shape.

12. The thermal device according to claim 11, wherein
a longitudinal width and a lateral width of the shape of the communication path in the cross-sectional view are different from each other.

13. The thermal device according to claim 10, wherein
in the cross-sectional view, one interior angle in the shape of the communication path is 90° or more, and a sum of all interior angles is 360° or more.

14. The thermal device according to claim 1, wherein
the metal pipe comprises an insertion portion located inside the communication path, a projecting portion located outside the communication path, and a flange portion located at the projecting portion, and
the flange portion is bonded to a surface of the container at which the opening portion is located.

15. The thermal device according to claim 14, wherein
a length of the insertion portion is shorter than a length of the projecting portion.

16. The thermal device according to claim 1, wherein
a space is provided between an inner peripheral surface of the communication path and an outer peripheral surface of the metal pipe.
